# EUROPÄISCHE PATENTSCHRIFT

(11) **EP 3 557 454 B1**
(45) Veröffentlichungstag und Bekanntmachung des Hinweises auf die Patenterteilung: **21.07.2021**
(21) Anmeldenummer: 18168443.2
(22) Anmeldetag: 20.04.2018
(51) Int. Cl.: G06F 30/20, G06F 30/00, H02B 3/00

(54) **VERFAHREN UND SYSTEM ZUR OPTIMIERBAREN KONFIGURATION EINES SCHALTSCHRANKS**
METHOD AND SYSTEM FOR OPTIMISABLE CONFIGURATION OF A SWITCHING CABINET
PROCÉDÉ ET SYST?ME DE CONFIGURATION OPTIMISÉE D'UNE ARMOIRE ÉLECTRIQUE

(43) Veröffentlichungstag der Anmeldung: 23.10.2019
(73) Patentinhaber: Rittal GmbH & Co. KG, 35745 Herborn (DE)
(72) Erfinder: WEICHSEL, Thomas, 41812 Erkelenz (DE); MICHELS, Thomas, 53842 Troisdorf (DE); MARTIN, Lars, 35516 Münzenberg (DE); ZACHRAI, Judith, 35745 Herborn (DE)
(74) Vertreter: Kietzmann, Lutz

(56) Entgegenhaltungen:
- WO-A1-2017/191059
- DE-A1-102011 117 679

## Beschreibung

Die vorliegende Erfindung betrifft ein Verfahren sowie ein System zur Konfiguration eines Schaltschranks, der eine modular aufgebaute Schaltschrankausstattung umfasst, die anwendungsspezifisch aus mehreren elektrischen und/oder elektronischen Einbaumodulen und weiteren optionalen Komponenten zusammengesetzt wird, wobei eine softwaretechnische Layout-Assistenzeinheit LA zur Umwandlung eines vorgegebenen elektrischen Schaltplans SP der Schaltschrankausstattung in ein dreidimensionales Layout L1 vorgesehen ist, welches eine Anordnung der Einbaumodule und der gegebenenfalls weiteren Komponenten in Zugriff auf eine an die Layout-Assistenzeinheit LA angeschlossene Einbaumodul-Bibliothek B in mindestens einem Schaltschrankgehäuse festlegt.

Das Einsatzgebiet der Erfindung erstreckt sich auf den Schaltanlagen- und Steuerungsbau. Schaltschränke werden vornehmlich im Rahmen industrieller Anwendungen genutzt. Ein Schaltschrank der hier interessierenden Art beherbergt die elektrischen und elektronischen Komponenten, welche gewöhnlich in Form normierter Einbaumodule ausgebildet sind, um vorzugsweise eine automatisierte Fertigungsanlage, eine verfahrenstechnische Anlage, eine Werkzeugmaschine oder dergleichen anzusteuern. Bei den im Schaltschrank untergebrachten Einbaumodulen handelt es sich meist um steuerungstechnische Komponenten, die nicht als Feldgeräte direkt an der Maschine angeordnet sind. Als Einbaumodule kommen beispielsweise speicherprogrammierbare Steuerungen, universelle Recheneinheiten, Frequenzumrichter für Drehzahlsteuerungen, Kommunikationsmodule für Busanbindungen zu unterschiedlichen Bussystemen, digitale Eingangs-/Ausgangs-Module oder auch analoge Eingangsmodule zum Einsatz. Daneben enthält ein Schaltschrank üblicherweise auch elektrische Klemmleisten zum Anschluss der elektrischen Verkabelung am Einsatzort, womit die Verbindung zur Stromversorgung und den anzusteuernden Maschinen und Anlagen hergestellt wird. Die Fertigung eines Schaltschranks mit der anwendungsspezifischen Schaltschrankausstattung erfolgt nach Maßgabe eines zuvor im Konzeptionsstadium erarbeiteten dreidimensionalen Layouts, welches auch die Stücklisteninformationen der zu verbauenden Komponenten umfasst.

Eine solche Konzeptionierung und Konstruktion von Schaltschrankausstattungen wird heutzutage softwarebasiert, beispielsweise durch EPLAN Pro Panel® in Form einer CADunterstützten Konstruktion erstellt. Die geplante Konstruktion umfasst insbesondere den dreidimensionalen Montageaufbau in Form eines Layouts, eine virtuelle Verdrahtung der elektrischen und elektronischen Einbaumodule und gegebenenfalls anderer Komponenten sowie eine auf die Schaltschrankausstattung abgestimmte Konfiguration von Kupferschienen und dergleichen für flexible Stromverteilersysteme. Die elektrischen oder elektronischen Einbaumodule können beispielsweise über Hutschienen im Schaltschrankgehäuse befestigt werden. Zur Komplettierung des Schaltschranks können auch optionale Komponenten, wie Ventilatoren, Lüfter, Filter, Wärmetauscher, Klimatisierungseinheiten, Innenbeleuchtungssysteme, Kabeleinführungen und dergleichen konzipiert werden.

Im modernen Schaltanlagen- und Steuerungsbau entsteht die geplante Konstruktion in der Regel seitens des Schaltanlagen- und Steuerungsbauers , welcher die Planung softwareunterstützt für seinen speziellen Anwendungsfall erstellt. Die geplante Konstruktion kann jedoch auch seitens des Schaltschrankherstellers erstellt werden. Als Planungshilfe steht ein Assistenzsystem mit angeschlossener Objektbibliothek zur Verfügung, mit welcher eine Schaltschrankkonfiguration unter Beachtung der geometrischen Abmessungen und der geltenden Normen und Erfahrungswerte erstellt werden kann. Die aus einer funktionellen Planung der Schaltschrankausstattung in Form eines elektrischen Schaltplans resultierende geplante Konstruktion wird anschließend beim Schaltanlagen- und Steuerungsbauer zur Fertigstellung in seiner Elektrowerkstatt angewiesen.

Die gemäß des allgemein bekannten Standes der Technik durchgeführte softwareunterstützte geplante Konstruktion zur Erstellung des dreidimensionalen Layouts zeichnet sich mit anderen Worten durch eine Layout-Assistenzeinheit aus, die im Zugriff auf eine hieran angeschlossene Einbaumodul-Bibliothek das Layouten der Schaltschrankausstattung unter Beachtung der baulichen Randbedingungen, beispielsweise Abstandsmaße, Zugänglichkeit oder elektrische Energieverbrauchsvorgabe unterstützt. Dabei orientiert sich die softwareunterstützte geplante Konstruktion an dem Prinzip eines Systembaukastens.

Aus der WO 2008/071309 A1 geht eine Schaltschrankanordnung mit mehreren einzelnen Schaltschränken hervor, die mittels Wandabschnitten in mehrere als Funktionsräume dienende Teilräume unterteilt sind, worin beispielsweise Niederspannungsanlagen, Einschübe, Kühlaggregate und andere Komponenten platzierbar sind. Dabei kann ein Teilraum beispielsweise eine elektrische Verteilschienenanordnung und hierauf aufgesetzte Geräteadapter zur Montage zugeordneter elektrischer oder elektronischer Einbaumodule aufnehmen.

Die EP 0 943 165 B1 offenbart verschiedene Ausstattungskonzepte von Schaltschränken. Bei einem ersten Ausführungsbeispiel umfasst ein baugruppenorientierter Schaltschrank ein Schaltschrankgehäuse, in dem mehrere elektrische und elektronische Bauteile und Geräte angeordnet sind. Im oberen Bereich des Schaltschrankgehäuses befinden sich mehrere Ein/Ausgabemodule, im mittleren Bereich sind mehrere Sicherungselemente und eine größere Anzahl von Leistungsschaltern platziert und im unteren Bereich sind Klemmeinrichtungen zur Befestigung von Kabelsträngen, die zu einzelnen Maschinen führen, untergebracht. Zur Verbindung der einzelnen Bauteile und Geräte untereinander sind in dem Schaltschrank mehrere Klemmen zur Zugangsverdrahtung, mehrere Klemmen zur Zwischenrangierung und mehrere Klemmen zur Abgangsrangierung angeordnet.

Gemäß einem zweiten in diesem Stand der Technik offenbarten Ausstattungskonzept sind in einem Schaltschrankgehäuse auf einer gemeinsamen Tragschiene verschiedene Einbaumodule befestigt. Der Schaltschrank ist funktionsblockorientiert aufgebaut, das heißt, dass nur diejenigen Einbaumodule enthalten sind, die für die Funktion einer Maschine notwendig sind. Darüber hinaus beinhaltet das Schaltschrankgehäuse auch mehrere Busklemmen zum Anschluss des Schaltschranks an ein Bussystem, eine Signalüberwachungseinheit, mehrere Ein/Ausgabemodule, ein Netzteil sowie Lastrelais. Im Boden des Schaltschrankgehäuses befinden sich Kabeldurchführungen, durch welche die Anschlussleitungen für Maschinen sowie Leitungen für zusätzliche Sensoren und/oder Aktoren in das Innere des Schaltschranks geführt werden können. Dieser Schaltschrank des zweiten Ausführungsbeispiels ist so ausgeführt, dass dieser mindestens der Schutzklasse IP65 entspricht.

Das Layout von Schaltschränken der vorstehend beschriebenen Art muss aus der Anwendung heraus definierte Rahmenbedingungen erfüllen und kann darüber hinaus nach zusätzlichen Aspekten optimiert werden, beispielsweise hinsichtlich der thermischen Belastbarkeit, der elektromagnetischen Verträglichkeit, der Packungsdichte an Einbaumodulen und sonstigen Komponenten, des elektrischen Energieverbrauchs und dergleichen. Allerdings stehen diese Optimierungsaspekte zumeist in einem konkurrierenden Verhältnis zueinander, so dass die Optimierung in Richtung eines Aspekts zu Lasten eines anderen Aspekts geht. Beispielsweise führt die Erhöhung der Packungsdichte meist zu einer höheren thermischen Belastung des Schaltschranks.

Die DE 10 2011 117 679 A1 offenbart eine technische Lösung zur Erstellung eines Layouts für die Anordnung von Anbaumodulen an einer Schalttafel mit definierten geometrischen Abmessungen. Um beim Anbau Überlappungen von Anbaumodulen zu vermeiden, wird bei der Erstellung des Layouts der zur Verfügung stehende Bauraum berücksichtigt. Dabei können auch mehrere Layouts vorgeschlagen werden, welche die Platzierung der Anbaumodule in mindestens einem Entwurf aus der Vielzahl der Schalttafeln als Funktion des Satzes von Regeln für den Entwurf umfassen.

Aus der WO 2017/191059 A1 geht ein Konfigurationssystem zur Umkonfiguration eines Schaltschranks hervor, welche sich einer Erkennungseinheit, beispielsweise einer Kamera, bedient. Hiermit erfolgt eine Bilderfassung eines Layouts, der sich eine Analyse hinsichtlich des zu Grunde liegenden elektrischen Schaltplans anschließt. Hiervon ausgehend werden Optimierungsmaßnahmen vorgeschlagen, welche sich aus dem elektrischen Schaltplan ableiten lassen. Eine derartig rückschließende Optimierung unterliegt den auf Schaltplanebene möglichen Maßnahmen.

Es ist daher die Aufgabe der vorliegenden Erfindung, ein Verfahren sowie System zur Konfiguration eines Schaltschranks der gattungsgemäßen Art dahingehend weiter zu verbessern, dass dessen dreidimensionales Layout in für den Nutzer einfacher Weise mit bestmöglicher Balance von möglichen Optimierungsaspekten gestaltet werden kann.

Die Aufgabe wird hinsichtlich eines Verfahrens zur Konfiguration eines Schaltschranks gemäß Anspruch 1 gelöst. Ein dieses Verfahren umsetzendes computergestütztes System ist in Anspruch 5 angegeben und ein das Verfahren verkörperndes Computerprogrammprodukt ist Inhalt des Anspruchs 11.

Die Erfindung schließt die verfahrenstechnische Lehre ein, dass die Konfiguration eines Schaltschranks zunächst von der Erstellung oder Bereitstellung einer funktionalen Planung der Schaltschrankausstattung in Form eines elektrischen Schaltplans SP ausgeht. Anschließend erfolgt eine Umwandlung des elektrischen Schaltplans SP der Schaltschrankausstattung in ein dreidimensionales Layout L1 zur Anordnung von zumindest mehreren elektrischen und/oder elektronischen Einbaumodulen in mindestens einem Schaltschrankgehäuse, wobei das dreidimensionale Layout L1 der Schaltschrankausstattung durch eine softwaretechnische Layout-Assistenzeinheit LA - beispielsweise das Produkt EPLAN Pro Panel® der Anmelderin - in Zugriff auf eine hieran angeschlossene Einbaumodul-Bibliothek erstellt wird. Erfindungsgemäß erfolgt anschließend eine Modifikation des so erstellten dreidimensionalen Layouts L1 durch einen in der Layout-Assistenzeinheit LA implementierten Abwandlungsalgorithmus Mod zur Erzeugung mindestens eines alternativen dreidimensionalen Layouts L2. Dabei ermittelt der Abwandlungsalgorithmus Mod zur Abwandlung des dreidimensionalen Layouts L1 in das alternative Layout L2 Werte einer Gütefunktion und optimiert die Abwandlung dergestalt, dass die Gütefunktion ein Extremum annimmt. Anschließend kann eine Übergabe des Schaltschranks gemäß dem alternativen dreidimensionalen Layout L2 an die Montagewerkstatt erfolgen.

Der erfindungswesentliche Abwandlungsalgorithmus macht sich die mathematische Gütefunktion zunutze. In der Gütefunktion ist das Ziel verkörpert, welches mit der Abwandlung erreicht werden soll, beispielsweise eine Erhöhung des Raumnutzungsgrades, also der Packungsdichte. Falls mehrere Ziele gleichzeitig erreicht werden sollen, so bietet dieses mathematische Modell die Voraussetzung dafür, dass im Falle von Zielkonflikten Kompromisse im Sinne eines kleinsten gemeinsamen Nenners auffindbar sind. Neben der Gütefunktion können auch harte Randbedingungen vorgegeben werden, wie eine Maximaltemperatur oder ein maximaler Energieverbrauch. Pro Layout-Variante kann eine Auswertung in mehreren Durchläufen stattfinden, welche mit der Gütefunktion getestet werden. Zur Suche der jeweils nächsten Variante kann ein beliebiges Optimierungsverfahren genutzt werden, das aus der Vorgeschichte der bisherigen Varianten eine neue Variante mit voraussichtlich verbessertem Wert der Gütefunktion ableitet.

Mit anderen Worten wird durch den Planer zunächst ein dreidimensionales Layout L1 in Umsetzung des elektrischen Schaltplans SP unter Nutzung der softwaretechnischen Layout-Assistenz erstellt. Anschließend kann vorgegeben werden, dass das dreidimensionale Layout, was auf beispielsweise zwei Schaltschränke verteilt angeordnet ist, gemäß dem originären Layout L1, auf eine geringere Montagefläche eines einziges Schaltschranks passen soll. Nach Maßgabe dieser Vorgabe erstellt der Abwandlungsalgorithmus Mod einen entsprechend angepassten Vorschlag für ein modifiziertes Layout L2, eventuell unter Missachtung von normalerweise geltenden Abstandsmaßen oder dergleichen. Da in diesem Fall jedoch ein höherer Raumnutzungsgrad Priorität vor vorgegebenen Abstandsmaßen hat, wird dem modifizierten Layout L2 Vorzug gegeben. Eventuell hieraus resultierende höhere Wärmeentwicklungen können dann beispielsweise durch Verbau einer Kühlungseinrichtung mit höherer Kühlleistung kompensiert werden.

Falls eine Vorzertifizierung des alternativen dreidimensionalen Layouts L2 ergibt, dass diese Ausführungsform zulässig ist, so wird gemäß einer weiteren die Erfindung verbessernden Maßnahme vorgeschlagen, dass dieses alternative dreidimensionale Layout L2 in der mit der Layout-Assistenzeinheit LA verbundenen Anwendungs-Datenbank A hinterlegt wird, um dieses bei zukünftigen Umwandlungen gleicher oder ähnlicher elektrischer Schaltpläne SP' als originär zulässiges Layout zu berücksichtigen. Durch diese Maßnahme erfolgt eine Anreicherung der Anwendungs-Datenbank A, welche insoweit nicht allein auf Ausführungsformen beschränkt wird, bei denen vorgegebene bauliche Randbedingungen und dergleichen starr beachtet werden. Durch diese Flexibilität ist ein stärker anwendungsorientiertes Layouten von Schaltschrankausstattungen möglich. Somit schafft die erfindungsgemäße Lösung eine Vorgehensweise, welches bei der Erstellung eines Layouts für einen Schaltschrank einzelne Optimierungsmöglichkeiten einschließlich ihrer Wechselwirkung zueinander berücksichtigt.

Systemtechnisch lässt sich die erfindungsgemäße Lösung durch eine zusätzliche Implementierung oder Zuordnung des Abwandlungsalgorithmus Mod in die Layout-Assistenzeinheit LA, welche ein Computer mit hierauf installierter Software EPLAN Pro Panel® sein kann, umgesetzt.

Erfindungsgemäß weist der Abwandlungsalgorithmus Mod eine parametrierbare Gütefunktion auf, die verschiedene änderbare Layout-Optimierungsparameter P1 bis Pn enthält. Dieser Layout-Optimierungsparameter stellt dem Planer - beispielsweise mittels eines auf einer grafischen Benutzeroberfläche nachgebildeten Drehreglers - für verschiedene Optimierungsrichtungen eine Eingabemöglichkeit bereit, um gewünschte Gewichtungen für eine Layout-Änderung zu wählen. Das System ermittelt anhand des Abwandlungsalgorithmus Mod ein aufeinander abgestimmtes, sinnvolles Verhältnis von verschiedenen vorgegebenen Layout-Optimierungsparametern und schlägt ein zugehöriges alternatives Layout L2 vor. Verschiedene Layout-Optimierungsparameter P1 bis Pn sind vorhanden, wovon nachfolgend eine nicht einschränkende Auswahl angegeben wird:
Ein erster Layout-Optimierungsparameter P1 beschreibt den Raumnutzungsgrad des zur Verfügung stehenden Schaltschrankvolumens im Verhältnis zu geometrischen Abmessungen der hierin zu verbauenden elektrischen und/oder elektronischen Einbaumodule.

Ein zweiter Layout-Optimierungsparameter P2 beschreibt einen thermischen Belastungsgrad unter Berücksichtigung der von den Einbaumodulen erzeugten Abwärme, der Umgebungswärme des Schaltschranks und gegebenenfalls der Wärmeabfuhrleistung einer optionalen Lüfter-/Klimaeinheit.

Ein dritter Layout-Optimierungsparameter P3 beschreibt den elektrischen Energieverbrauchsgrad unter Berücksichtigung zumindest der elektrischen Leistungsaufnahme aller Einbaumodule. Zwar hängt die elektrische Gesamtleistung von der elektrotechnischen Auslegung der Schaltschrankausstattung ab, jedoch könnten alternative Einbaumodule in Frage kommen, die sich bei derselben Funktion in der Leistungsaufnahme unterscheiden. Daher kann auch dahingehend optimiert werden.

Ein vierter Layout-Optimierungsparameter P4 beschreibt einen EMV-Grad (EMV = elektromagnetische Verträglichkeit), welcher die elektromagnetische Emission der Einbaumodule berücksichtigt.

Ein fünfter Layout-Optimierungsparameter P5 beschreibt den Verdrahtungslängen-Grad, um Vorgaben hinsichtlich minimaler oder maximaler Kabellängen bei der Anordnung von Einbaumodulen im Schaltschrankgehäuse zu berücksichtigen.

Da sich einige dieser hier nur exemplarisch angegebenen Layout-Optimierungsparameter P1 bis P5 widersprechen, also die Optimierung hinsichtlich eines Parameters zu Lasten eines anderen Parameters gehen kann, ermöglicht die mathematische Methodik der parametrierbaren Gütefunktion eine bestmögliche Balance zwischen verschiedenen Optimierungsparametern, um einen diesbezüglichen Kompromiss aufzufinden. Dabei kann im Sinne einer Priorisierung einem Parameter eine höhere Priorität als einem anderen Parameter beigemessen werden. Mithilfe des erfindungsgemäßen Abwandlungsalgorithmus Mod ist es also möglich, die Schaltschrankausstattung bezüglich unterschiedlicher Kriterien hinsichtlich Raumnutzung, thermischer Belastung, elektrischer Energieverbrauch, EMV, Materialaufwand für Verdrahtung und dergleichen zu optimieren.

Das erfindungsgemäße Verfahren lässt sich vorteilhafterweise in Form eines Computerprogrammprodukts ausbilden, dessen Programmcodemittel das Verfahren durchführen. Das Computerprogrammprodukt kann vorzugsweise auf der Layout-Assistenzeinheit LA eines computergestützten Konstruktionssystems ablaufen oder auf einem computerlesbaren Datenträger oder in einem Cloud-Speicher abgespeichert und so zur Verfügung gestellt werden.

Weitere die Erfindung verbessernde Maßnahmen werden nachstehend gemeinsam mit der Beschreibung eines bevorzugten Ausführungsbeispiels der Erfindung anhand der Figuren näher dargestellt. Es zeigt:
- Fig. 1: eine schematische Darstellung eines computergestützten Systems zur Konfiguration eines Schaltschranks, und
- Fig. 2: eine Ablaufdarstellung des von dem System durchgeführten Verfahrens zur optimierbaren Konfiguration eines Schaltschranks.

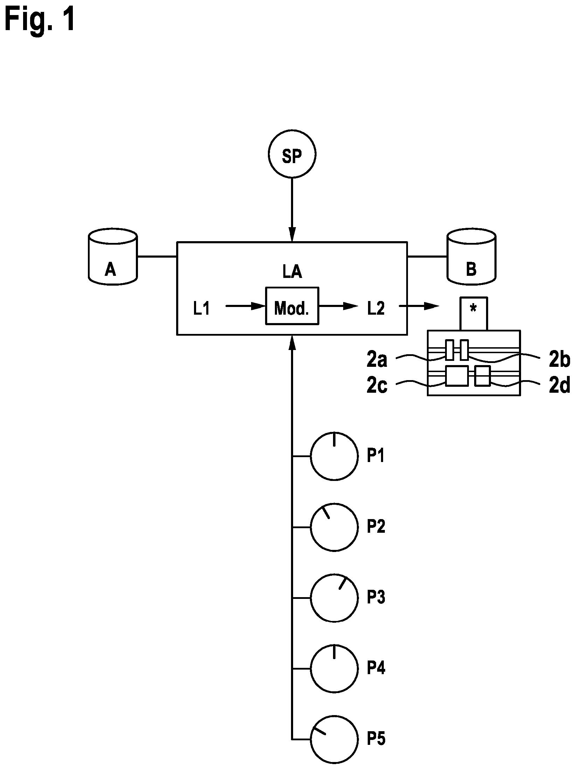

Gemäß Fig. 1 umfasst ein computergestütztes System zur Durchführung einer Konfiguration eines Schaltschranks im Kern eine softwaretechnische Layout-Assistenzeinheit LA, welche in Form eines Rechners mit der anwendungsspezifischen Software ausgebildet ist. Dieser softwaretechnischen Layout-Assistenzeinheit LA geht als Eingangsinformation der elektrische Schaltplan SP einer anwendungsindividuell konfigurierten Schaltschrankausstattung zu. Hieraus ermittelt die softwaretechnische Layout-Assistenzeinheit LA ein dreidimensionales Layout L1 unter Zugriff auf eine hieran angeschlossene Einbaumodul-Bibliothek B. Die Einbaumodul-Bibliothek B enthält je ein digitales Modell aller elektrischen und elektronischen Einbaumodule sowie gegebenenfalls weiterer Komponenten, welche als Schaltschrankausstattung infrage kommen können. Hiermit sind die geometrischen Abmessungen, alle wesentlichen elektrischen Parameter und Einbaurandbedingungen, wie Minimalabstände oder Kompatibilität, verknüpft. Durch zusätzlichen Rückgriff auf eine Anwendungs-Datenbank A kann die Layout-Assistenzeinheit LA einen Abgleich mit vorgefertigten oder ähnlichen historischen dreidimensionalen Layouts vornehmen, so dass die Anwendungs-Datenbank A auch eine Art Wissensspeicher darstellt. Anhand dieser historischen Layouts kann sich der Nutzer der Layout-Assistenzeinheit LA an anderen funktionierenden Layouts oder Teil-Layouts bei einer aktuellen Konfigurationsaufgabe orientieren.

Die Layout-Assistenzeinheit LA umfasst den hier erfindungswesentlichen Abwandlungsalgorithmus Mod, mit welchem die Möglichkeit der Erzeugung eines alternativen dreidimensionalen Layouts L2 besteht. Durch den Schritt der Abwandlung wird eine Optimierung des zunächst erzeugten Layouts L1 in Richtung verschiedener Zielvorgaben (Layout-Optimierungsparameter) möglich. Hierzu ermittelt der Abwandlungsalgorithmus Mod zur Abwandlung des Layouts L1 in das alternative Layout L2 Werte einer Gütefunktion und optimiert die besagte Abwandlung derart, dass die Gütefunktion ein Extremum annimmt. Im Extremum, also einen Maximal- oder Minimalwert, in welchem der Anstieg Null ist, liegt das Optimum der Gütefunktion.

Als verschiedenartig vorgebbare Layout-Optimierungsparameter P1 bis P5 kommen im Rahmen dieses Ausführungsbeispiel der Layout-Optimierungsparameter P1 infrage, mit welchem ein Raumnutzungsgrad des zur Verfügung stehenden Schaltschrankvolumens als Optimierungsziel vorgebbar ist. So kann beispielsweise zu einem höheren Raumnutzungsgrad hin optimiert werden, bei welchem die Packungsdichte der im Schaltschrankgehäuse 1 verbauten elektrischen und/oder elektronischen Einbaumodule 2a bis 2d erhöht wird, indem beispielsweise die normalerweise vorgegebenen Abstandsmaße untereinander überschritten werden.

Als weiterer Layout-Optimierungsparameter P2 kann der thermische Belastungsgrad variiert werden. Bei Einstellung eines höheren thermischen Belastungsgrades wird beispielsweise in Kauf genommen, dass die von den Einbaumodulen 2a bis 2d erzeugte Abwärme einen zunächst vorgegebenen Grenzwert überschreitet. Dabei kann auch die Umgebungswärme des Schaltschrankgehäuses 1 und die Wärmeabfuhrleistung einer Lüfter-/Klimaeinheit 3 mit in die Kalkulation der Wärmebilanz mit einbezogen werden.

Als Layout-Optimierungsparameter P3 kann außerdem der elektrische Energieverbrauch aller verbauten Einbaumodule 2a bis 2d und gegebenenfalls weiterer Komponenten berücksichtigt werden. Soll beispielsweise zu einem geringeren Energieverbrauchsgrad hin optimiert werden, so werden gezielt Einbaumodule 2a bis 2d mit geringerer Leistungsaufnahme als Substitut ausgewählt, falls diese in der Einbaumodul-Bibliothek B zur Verfügung stehen.

Als Layout-Optimierungsparameter P4 kann auch der EMV-Grad berücksichtigt werden. Ist beispielsweise in einer Anwendungsumgebung eine höhere elektromagnetische Emission der verbauten Einbaumodule 2a bis 2d sowie eventuell weiterer Komponenten möglich, so kann zu einem höheren EMV-Grad hin optimiert werden, um beispielsweise kostengünstigere Einbaumodule 2a bis 2d als Substitute zu berücksichtigen, sofern diese in der Einbaumodul-Bibliothek B zur Verfügung gestellt werden.

Als weiterer Layout-Optimierungsparameter P5 kann auch ein Verdrahtungslängen-Grad der schrankinternen Verdrahtung berücksichtigt werden, um beispielsweise Vorgaben hinsichtlich minimaler oder maximaler Kabellängen bei der Anordnung der Einbaumodule 2a bis 2d im Schaltschrankgehäuse 1 zu berücksichtigen. Hierdurch kann beispielsweise der Materialverbrauch an Verdrahtungskabeln gesenkt werden, um weitere Materialkosten einzusparen.

Da es zu Konstellationen kommen kann, bei denen zumindest einige der vorstehend angegebenen Layout-Optimierungsparameter P1 bis P5 in Zielkonflikt miteinander stehen, wählt der Abwandlungsalgorithmus Mod die beste Kompromisslösung aus. Die verschiedenen Layout-Optimierungsparameter P1 bis P5 können beispielsweise auf einer grafischen Benutzeroberfläche der Layout-Assistenzeinheit LA in Form von Drehreglern mit Minimum-Maximum-Skala ausgebildet sein. Daneben kommt natürlich auch eine hardwaremäßige Ausgestaltung derartiger Drehregler oder dergleichen auf einem Bedienpaneel in Betracht.

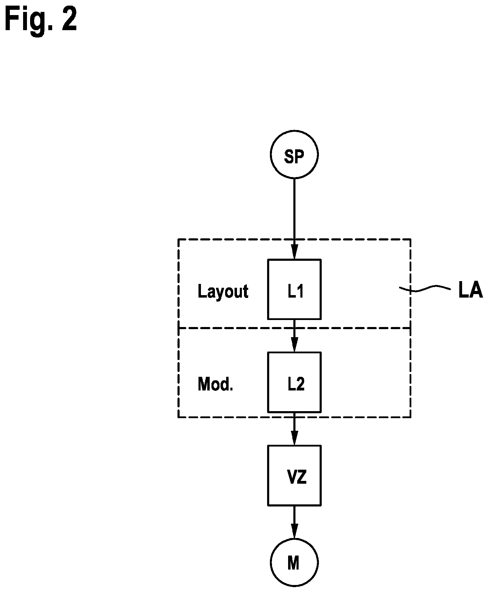

Die Fig. 2 illustriert exemplarisch die bevorzugte Abfolge der unterschiedlichen Verfahrensschritte, welche mit dem vorstehend beschriebenen computergestützten System durchgeführt werden.

Das Verfahren geht aus von einer Bereitstellung einer funktionalen Planung der Schaltschrankausstattung in Form eines elektrischen Schaltplans SP. Anschließend erfolgt eine Umwandlung dieses elektrischen Schaltplans SP der Schaltschrankausstattung innerhalb einer softwaretechnischen Layout-Assistenzeinheit LA in ein dreidimensionales Layout L1 mit allen erforderlichen Stücklisteninformationen. Mit dem dreidimensionalen Layout L1 steht die Normalform einer Schaltschrankkonfiguration zur Verfügung. Anschließend wird eine Modifikation des erstellten dreidimensionalen Layouts L1 durch die Layout-Assistenzeinheit LA zur Erzeugung mindestens eines alternativen dreidimensionalen Layouts L2 durchgeführt, indem ein Abwandlungsalgorithmus Mod der Layout-Assistenzeinheit LA zur Abwandlung Werte einer Gütefunktion ermittelt und die Abwandlung derart optimiert, dass die Gütefunktion ein Extremum annimmt. Hierdurch kann beispielsweise in Richtung einer höheren Packungsdichte verbauter Komponenten optimiert werden. Nachfolgend wird ein Prüfen des dreidimensionalen Layouts L2 auf Zulässigkeit bezüglich baulicher Randbedingungen und/oder technischer Normen durchgeführt, was einer Vorzertifizierung vor Übergabe des modifizierten dreidimensionalen Layouts L2 an die Montage M in Form einer CAD-unterstützt erstellten Konstruktion entspricht.

Im Rahmen des Verfahrens zur Konfiguration eines Schaltschranks ist es auch denkbar, dass das alternative und vorzertifizierte dreidimensionale Layout L2 in einer mit der Layout-Assistenzeinheit LA verbundenen Anwendungs-Datenbank hinterlegt wird, um dieses bei zukünftigen Umwandlungen gleicher oder ähnlicher elektrischer Schaltpläne SP' als originär zulässiges Layout zu berücksichtigen.

### Bezugszeichenliste

- A: Anwendungs-Datenbank
- B: Einbaumodul-Bibliothek
- LA: Layout-Assistenzeinheit
- L1: Layout (aus Schaltplan)
- L2: Layout (modifiziert)
- SP: Elektrischer Schaltplan
- Mod: Abwandlungsalgorithmus
- P1...n: Layout-Optimierungsparameter
- VZ: Vorzertifizierung

## Patentansprüche

1. Verfahren zur Konfiguration eines Schaltschranks, der eine modular aufgebaute Schaltschrankausstattung umfasst, die anwendungsspezifisch aus mehreren elektrischen und/oder elektronischen Einbaumodulen (2a - 2d) und weiteren optionalen Komponenten zusammengesetzt wird, gemäß folgender Schritte:
- Erstellung einer funktionellen Planung der Schaltschrankausstattung in Form eines elektrischen Schaltplans (SP),
- Umwandlung des elektrischen Schaltplans (SP) der Schaltschrankausstattung in ein dreidimensionales Layout (L1) zur Anordnung von zumindest mehreren elektrischen und/oder elektronischen Einbaumodulen (2a - 2d) in mindestens einem Schaltschrankgehäuse (1), wobei das dreidimensionale Layout (L1) der Schaltschrankausstattung durch eine softwaretechnische Layout-Assistenzeinheit (LA) in Zugriff auf eine hieran angeschlossene Einbaumodul-Bibliothek (B) erstellt wird, **gekennzeichnet durch eine**
- Modifikation des erstellten dreidimensionalen Layouts (L1) durch einen in der Layout-Assistenzeinheit (LA) implementierten Abwandlungsalgorithmus (Mod) zur Erzeugung mindestens eines alternativen dreidimensionalen Layouts (L2), wobei der Abwandlungsalgorithmus (Mod) zur Abwandlung des Layouts (L1) in das alternative Layout (L2) Werte einer Gütefunktion ermittelt und die Abwandlung derart optimiert, dass die Gütefunktion ein Extremum annimmt,
indem der Abwandlungsalgorithmus (Mod) eine parametrierbare Gütefunktion enthält, der mehrere verschiedene Layout-Optimierungsparameter (P1 ... Pn) vorgegeben werden, ausgewählt aus einer Parametergruppe, umfassend Raumnutzungsgrad, Belastungsgrad, Energieverbrauchsgrad, EMV-Grad, Verdrahtungslängen-Grad,
wobei die Layout-Optimierungsparameter (P1 ... Pn) dem Planer für verschiedene Optimierungsrichtungen eine Eingabe bereitstellt, um gewünschte Gewichtungen für eine Layout-Abwandlung zu wählen,
- Übergabe zur Montage des Schaltschranks gemäß des alternativen dreidimensionalen Layouts (L2).

2. Verfahren nach Anspruch 1,
**dadurch gekennzeichnet, dass** die Umwandlung des elektrischen Schaltplans (SP) der Schaltschrankausstattung in ein dreidimensionales Layout (L1) ein Prüfen desselben auf Zulässigkeit bezüglich baulicher Randbedingungen und/oder technischen Normen beinhaltet, die in einer Anwendungs-Datenbank (A) hinterlegt sind.

3. Verfahren nach Anspruch 1 oder 2,
**dadurch gekennzeichnet, dass** das alternative dreidimensionale Layout (L2) in der mit der Layout-Assistenzeinheit (LA) verbundenen Anwendungs-Datenbank (A) hinterlegt wird, um dieses bei zukünftigen Umwandlungen gleicher oder ähnlicher elektrischer Schaltpläne (SP') als originär zulässiges Layout zu berücksichtigen.

4. Verfahren nach Anspruch 1,
**dadurch gekennzeichnet, dass** das alternative dreidimensionale Layout (L2) vor Übergabe an die Montage (M) des Schaltschranks eine Vorzertifizierung (VZ) durchläuft, bei welcher eine digitalisierte Prüfung auf normkonforme Umsetzung stattfindet.

5. Computergestütztes System zur Durchführung des Verfahren zur Konfiguration eines Schaltschranks nach einem der vorstehenden Ansprüche, umfassend eine softwaretechnische Layout-Assistenzeinheit (LA) zur Umwandlung eines vorgegebenen elektrischen Schaltplans (SP) einer Schaltschrankausstattung in ein dreidimensionales Layout (L1), das eine Anordnung von zumindest mehreren elektrischen und/oder elektronischen Einbaumodulen (2a - 2d) in Zugriff auf eine an die Layout-Assistenzeinheit (LA) angeschlossene Einbaumodul-Bibliothek (B) in mindestens einem Schaltschrankgehäuse (1) festlegt,
**gekennzeichnet durch,** einen in der Layout-Assistenzeinheit (LA) implementierten oder dieser zugeordneten Abwandlungsalgorithmus (Mod) zur Erzeugung mindestens eines alternativen dreidimensionalen Layouts (L2), wobei der Abwandlungsalgorithmus (Mod) zur Abwandlung des Layouts (L1) in das alternative Layout (L2) Werte einer Gütefunktion ermittelt und die Abwandlung derart optimiert, dass die Gütefunktion ein Extremum annimmt, wobei der Abwandlungsalgorithmus (Mod) eine parametrierbare Gütefunktion enthält, die mehrere verschiedene vorgegebene Layout-Optimierungsparameter (P1 ... Pn) aufweist, ausgewählt aus einer Parametergruppe, umfassend Raumnutzungsgrad, Belastungsgrad, Energieverbrauchsgrad, EMV-Grad, Verdrahtungslängen-Grad,
wobei die Layout-Optimierungsparameter (P1 ... Pn) dem Planer für verschiedene Optimierungsrichtungen eine Eingabe bereitstellt, um gewünschte Gewichtungen für eine Layout-Abwandlung zu wählen.

6. Computergestütztes System nach Anspruch 5,
**dadurch gekennzeichnet, dass** der Layout-Optimierungsparameter (P1) als Raumnutzungsgrad des zur Verfügung stehenden Schaltschrankvolumens im Verhältnis zu geometrischen Abmessungen der hierin zu verbauenden elektrischen und/oder elektronischen Einbaumodule (2a - 2d) ausgebildet ist.

7. Computergestütztes System nach Anspruch 5,
**dadurch gekennzeichnet, dass** der Layout-Optimierungsparameter (P2) als thermischer Belastungsgrad unter Berücksichtigung der von den Einbaumodulen (2a - 2d) erzeugten Abwärme, der Umgebungswärme des Schaltschrankgehäuses (1) und der Wärmeabfuhrleistung einer optionalen Lüfter-/Klimaeinheit (3) ausgebildet ist.

8. Computergestütztes System nach Anspruch 5,
**dadurch gekennzeichnet, dass** der Layout-Optimierungsparameter (P3) als elektrischer Energieverbrauchsgrad unter Berücksichtigung zumindest der elektrischen Leistungsaufnahme der Einbaumodule (2a - 2d) ausgebildet ist.

9. Computergestütztes System nach Anspruch 5,
**dadurch gekennzeichnet, dass** der Layout-Optimierungsparameter (P4) als EMV-Grad ausgebildet ist, welcher die elektromagnetische Emission der Einbaumodule (2a - 2d) berücksichtigt.

10. Computergestütztes System nach Anspruch 5,
**dadurch gekennzeichnet, dass** der Layout-Optimierungsparameter (P5) als Verdrahtungslängen-Grad ausgebildet ist, um Vorgaben hinsichtlich minimaler oder maximaler Kabellängen bei der Anordnung der Einbaumodule (2a - 2d) im Schaltschrankgehäuse (1) zu berücksichtigen.

11. Computerprogrammprodukt mit Programmcodemitteln zur Durchführung des Verfahrens nach einem der Ansprüche 1 bis 4, wenn das Computerprogrammprodukt auf einer Layout-Assistenzeinheit (LA) eines computergestützten Systems nach einem der Ansprüche 5 bis 10 abläuft oder auf einem computerlesbaren Datenträger oder in einem Cloud-Speicher abgespeichert ist.

## Claims

1. Method for configuring a switching cabinet which comprises modularly designed switching cabinet equipment which is assembled in an application-specific manner from a number of electrical and/or electronic built-in modules (2a - 2d) and further optional components, according to the following steps:
- Preparation of a functional design of the switching cabinet equipment in the form of an electrical circuit diagram (SP),
- conversion of the electrical circuit diagram (SP) of the switching cabinet equipment into a three-dimensional layout (L1) for the arrangement of at least a number of electrical and/or electronic built-in modules (2a - 2d) in at least one switching cabinet housing (1), wherein the three-dimensional layout (L1) of the switching cabinet equipment is prepared by a software-technical layout assistance unit (LA) in access to an installation module library (B) connected thereto,
**characterised by an**
- modification of the prepared three-dimensional layouts (L1) by a modification algorithm (Mod) implemented in the layout assistance unit (LA) for generating at least one alternative three-dimensional layout (L2), the modification algorithm (Mod) for modifying the layout (L1) into the alternative layout (L2) determining values of a quality function and optimizing the modification in such a way that the quality function assumes an extremum,
in that the modification algorithm (Mod) includes a parameterizable quality function to which a number of different layout optimization parameters (P1 ... Pn) are given, selected from a parameter group comprising space utilization level, load level, power consumption level, EMC level, wiring length level,
where the layout optimization parameters (P1 ... Pn) provide an input to the planner for different optimization directions to select desired weightings for a layout modification,
- handover for assembly of the switching cabinet according to the alternative three-dimensional layout (L2).

2. Method according to claim 1,
**characterized in that** the conversion of the electrical circuit diagram (SP) of the switching cabinet equipment into a three-dimensional layout (L1) includes a checking of the same for permissibility with respect to structural boundary conditions and/or technical standards stored in an application database (A) .

3. Method according to claim 1 or 2,
**characterized in that** the alternative three-dimensional layout (L2) is stored in the application database (A) connected to the layout assistance unit (LA) in order to take it into account as an original permissible layout in future conversions of identical or similar electrical circuit diagrams (SP).

4. Method according to claim 1,
**characterized in that** the alternative three-dimensional layout (L2) is subjected to a pre-certification (VZ) before the handover to the assembly (M) of the switching cabinet, in which a digitized test for standard-compliant implementation takes place.

5. Computer-aided system for carrying out the method for configuring a switching cabinet according to one of the preceding claims, comprising a software-technical layout assistance unit (LA) for converting a predetermined electrical circuit diagram (SP) of a switching cabinet equipment into a three-dimensional layout (L1), which determines an arrangement of at least a number of electrical and/or electronic built-in modules (2a - 2d) in access to a built-in module library (B) connected to the layout assistance unit (LA) in at least one switching cabinet housing (1),
**characterized by**, a modification algorithm (Mod) implemented in or associated with the layout assistance unit (LA) for generating at least one alternative three-dimensional layout (L2), wherein the modification algorithm (Mod) for modifying the layout (L1) into the alternative layout (L2) determines values of a quality function and optimizes the modification in such a way that the quality function assumes an extremum, wherein the modification algorithm (Mod) contains a parameterizable quality function which has a number of different predetermined layout optimization parameters (P1 ... Pn) selected from a parameter group comprising space utilization level, load level, power consumption level, EMC level, wiring length level, wherein the layout optimization parameters (P1 ... Pn) provide an input to the planner for different optimization directions in order to select desired weightings for a layout modification.

6. Computer-aided system according to claim 5, **characterized in that** the layout optimization parameter (P1) is designed as a space utilization factor of the available switching cabinet volume in relation to geometric dimensions of the electrical and/or electronic built-in modules (2a - 2d) to be installed therein.

7. Computer-aided system according to claim 5, **characterized in that** the layout optimization parameter (P2) is designed as a thermal load level taking into account the waste heat generated by the built-in modules (2a - 2d), the ambient heat of the switching cabinet housing (1) and the heat dissipation capacity of an optional fan/air conditioning unit (3) .

8. Computer-aided system according to claim 5,
**characterized in that** the layout optimization parameter (P3) is designed as an electrical energy consumption level taking into account at least the electrical power consumption of the built-in modules (2a - 2d).

9. Computer-aided system according to claim 5,
**characterized in that** the layout optimization parameter (P4) is designed as an EMC level, which takes into account the electromagnetic emission of the built-in modules (2a - 2d).

10. Computer-aided system according to claim 5,
**characterized in that** the layout optimization parameter (P5) is designed as a wiring length level in order to take into account specifications regarding minimum or maximum cable lengths when arranging the built-in modules (2a - 2d) in the switching cabinet housing (1).

11. A computer program product comprising program code means for carrying out the method according to any one of claims 1 to 4, when the computer program product is installed on a layout assistant unit (LA) of a computerized system according to any one of claims 5 to 10 or is stored on a computer-readable data carrier or in cloud storage.

## Revendications

1. Procédé de configuration d'une armoire de distribution comprenant un équipement d'armoire de distribution monté de manière modulaire, assemblé à partir de plusieurs modules intégrés électriques et/ou électroniques (2a - 2d) spécifiques à l'application et d'autres composants facultatifs, comportant les étapes suivantes consistant à :
- réaliser une étude fonctionnelle de l'équipement d'armoire de distribution sous forme de schéma de distribution électrique (SP),
- convertir le schéma de distribution électrique (SP) de l'équipement d'armoire de distribution en une topologie tridimensionnelle (L1) pour agencer au moins plusieurs modules intégrés électriques et/ou électroniques (2a - 2d) dans au moins un coffret d'armoire de distribution (1), dans lequel la topologie tridimensionnelle (L1) de l'équipement d'armoire de distribution est établie par une unité d'assistance topologique logicielle (LA) ayant accès à une bibliothèque de modules intégrés (B) reliée à celle-ci, **caractérisé par** les étapes consistant à :
- modifier la topologie tridimensionnelle établie (L1) par un algorithme de modification (Mod) implémenté dans l'unité d'assistance topologique (LA) pour générer au moins une topologie tridimensionnelle alternative (L2), dans lequel l'algorithme de modification (Mod) détermine des valeurs d'une fonction qualité pour modifier la topologie (L1) en topologie alternative (L2) et optimise la modification de sorte que la fonction qualité atteint un extremum,
l'algorithme de modification (Mod) contenant une fonction qualité paramétrable pour laquelle ont été prédéfinis plusieurs paramètres d'optimisation de topologie (P1 ... Pn) différents choisis parmi un groupe de paramètres comportant un niveau d'utilisation d'espace, un niveau de charge, un niveau de consommation d'énergie, un niveau de CEM et un niveau de longueur de câblage,
dans lequel le paramètre d'optimisation de topologie (P1 ... Pn) fournit au concepteur une entrée pour différentes directions d'optimisation afin de choisir des pondérations souhaitées pour une modification de topologie,
- transférer les données pour le montage de l'armoire de distribution conformément à la topologie tridimensionnelle alternative (L2).

2. Procédé selon la revendication 1,
**caractérisé en ce que** la conversion du schéma de distribution électrique (SP) de l'équipement d'armoire de distribution en une topologie tridimensionnelle (L1) inclut un contrôle de fiabilité de cette dernière par rapport aux conditions structurelles aux limites et/ou aux normes techniques qui sont stockées dans une base de données d'application (A).

3. Procédé selon la revendication 1 ou 2,
**caractérisé en ce que** la topologie tridimensionnelle alternative (L2) est stockée dans la base de données d'application (A) reliée à l'unité d'assistance topologique (LA) afin de la considérer comme une topologie initialement fiable lors de futures conversions de plans de distribution électriques (SP') identiques ou analogues.

4. Procédé selon la revendication 1,
**caractérisé en ce que**, avant le transfert pour le montage (M) de l'armoire de distribution, la topologie tridimensionnelle alternative (L2) réalise une pré-certification (VZ) au cours de laquelle un contrôle numérisé de conversion normalisée est effectué.

5. Système assisté par ordinateur pour mettre en œuvre le procédé de configuration d'une armoire de distribution selon l'une des revendications précédentes, comprenant une unité d'assistance topologique logicielle (LA) pour convertir un schéma de distribution électrique (SP) prédéfini d'un équipement d'armoire de distribution en une topologie tridimensionnelle (L1) qui établit un agencement d'au moins plusieurs modules intégrés électriques et/ou électroniques (2a - 2d) ayant accès à une bibliothèque de modules intégrés (B) reliée à l'unité d'assistance topologique (LA) dans au moins un coffret d'armoire de distribution (1),
**caractérisé par** un algorithme de modification (Mod) implémenté dans l'unité d'assistance topologique (LA) ou associé à celle-ci pour générer au moins une topologie tridimensionnelle alternative (L2), dans lequel l'algorithme de modification (Mod) détermine des valeurs d'une fonction qualité pour modifier la topologie (L1) en topologie alternative (L2) et la modification est optimisée de sorte que la fonction qualité atteint un extremum, dans lequel l'algorithme de modification (Mod) contient une fonction qualité paramétrable qui comporte plusieurs paramètres d'optimisation de topologie (P1 ... Pn) différents prédéfinis, choisis parmi un groupe de paramètres comportant un niveau d'utilisation d'espace, un niveau de charge, un niveau de consommation d'énergie, un niveau de CEM et un niveau de longueur de câblage,
dans lequel le paramètre d'optimisation de topologie (P1 ... Pn) fournit au concepteur une entrée pour différentes directions d'optimisation afin de choisir des pondérations souhaitées pour une modification de topologie.

6. Système assisté par ordinateur selon la revendication 5,
**caractérisé en ce que** le paramètre d'optimisation de topologie (P1) est configuré sous la forme d'un niveau d'utilisation d'espace du volume d'armoire de distribution disponible par rapport aux dimensions géométriques des modules intégrés électriques et/ou électroniques (2a - 2d) à y intégrer.

7. Système assisté par ordinateur selon la revendication 5,
**caractérisé en ce que** le paramètre d'optimisation de topologie (P2) est configuré sous la forme d'un niveau de charge thermique en tenant compte de la chaleur cédée générée par les modules intégrés (2a - 2d), de la chaleur de l'environnement du coffret d'armoire de distribution (1) et de l'efficacité en termes de dissipation thermique d'une unité de ventilation/climatisation facultative (3).

8. Système assisté par ordinateur selon la revendication 5,
**caractérisé en ce que** le paramètre d'optimisation de topologie (P3) est configuré sous la forme d'un niveau de consommation d'énergie électrique en tenant compte au moins de la puissance absorbée par les modules intégrés (2a - 2d).

9. Système assisté par ordinateur selon la revendication 5,
**caractérisé en ce que** le paramètre d'optimisation de topologie (P4) est configuré sous la forme d'un niveau de CEM qui tient compte de l'émission électromagnétique des modules intégrés (2a - 2d).

10. Système assisté par ordinateur selon la revendication 5,
**caractérisé en ce que** le paramètre d'optimisation de topologie (P5) est configuré sous la forme d'un niveau de longueur de câblage afin de tenir compte d'exigences concernant des longueurs de câblage minimales ou maximales lors de l'agencement des modules intégrés (2a - 2d) dans le coffret d'armoire de distribution (1).

11. Produit de programme informatique ayant des moyens de code de programme pour mettre en œuvre le procédé selon l'une des revendications 1 à 4, lorsque le produit de programme informatique s'exécute sur une unité d'assistance topologique (LA) d'un système assisté par ordinateur selon l'une des revendications 5 à 10, ou est enregistré sur un support de données lisible par ordinateur ou dans une mémoire en nuage.
